# EUROPÄISCHE PATENTSCHRIFT

(11) **EP 0 898 372 B1**
(45) Veröffentlichungstag und Bekanntmachung des Hinweises auf die Patenterteilung: **12.11.2003**
(21) Anmeldenummer: 98113936.3
(22) Anmeldetag: 24.07.1998
(51) Int. Cl.: H03L 7/089, H03L 7/14

(54) **Verfahren und Vorrichtung zum Einstellen der Schwingfrequenz eines Oszillators**
Process and apparatus for adjusting the frequency of an oscillator
Procédé et dispositif de réglage de la fréquence d'un oscillateur

(30) Priorität: 21.08.1997 DE 19736464
(43) Veröffentlichungstag der Anmeldung: 24.02.1999
(73) Patentinhaber: Infineon Technologies AG, 81669 München (DE)
(72) Erfinder: Heinen, Stefan, 47802 Krefeld (DE); Beyer, Stefan, 86415 Mering (DE)
(74) Vertreter: Barth, Stephan Manuel, Dr.

(56) Entgegenhaltungen:
- US-A- 5 598 405
- US-A- 5 606 290
- PATENT ABSTRACTS OF JAPAN vol. 007, no. 280 (E-216), 14. Dezember 1983 & JP 58 159029 A (NIPPON DENSHIN DENWA KOSHA), 21. September 1983

## Beschreibung

Die vorliegende Erfindung betrifft ein Verfahren gemäß dem Oberbegriff des Patentanspruchs 1 und eine Vorrichtung gemäß dem Oberbegriff des Patentanspruchs 6, wie aus der US-A-5,606,290 oder der JP 58 159029A bekannt.

Die US-A-5,598,405 beschreibt einen TDMA/TDD-Sendeempfänger mit einer Phasenregelschleife zum Regeln der Ausgangsfrequenz eines spannungsgesteuerten Oszillators.

Ein derartiges Verfahren bzw. derartige Vorrichtungen kommen beispielsweise, aber bei weitem nicht ausschließlich in einem nach dem DECT-Standard arbeitenden Funksystem zum Einsatz.

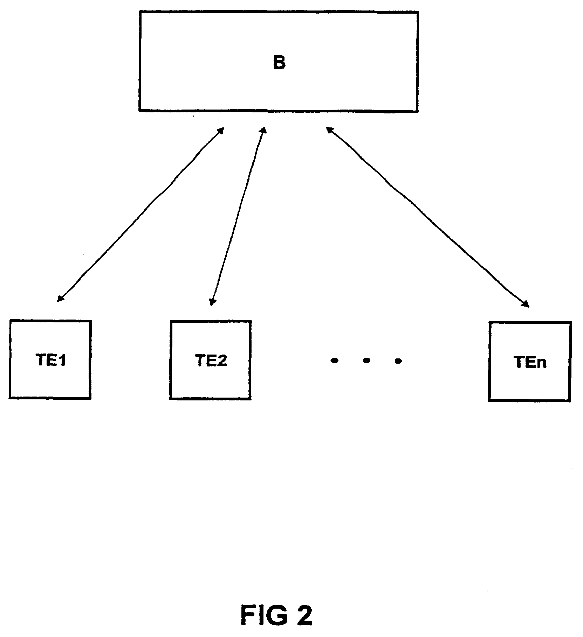

Der prinzipielle Aufbau eines nach dem DECT-Standard arbeitenden Funksystems ist in Figur 2 veranschaulicht.

Das in der Figur 2 gezeigte System besteht aus einer Basisstation B und mehreren schnurlosen Telekommunikationsendeinrichtungen TE1 bis TEn. Die schnurlosen Telekommunikationsendeinrichtungen TE1 bis TEn sind im betrachteten Beispiel Mobiltelefone, welche in der Lage sind, über Funk mit der Basisstation B zu kommunizieren; anstelle der schnurlosen Telekommunikationsendeinrichtungen können auch schnurlose Anschlußdosen zum Anschluß schnurgebundener Telekommunikationsendeinrichtungen zum Einsatz kommen.

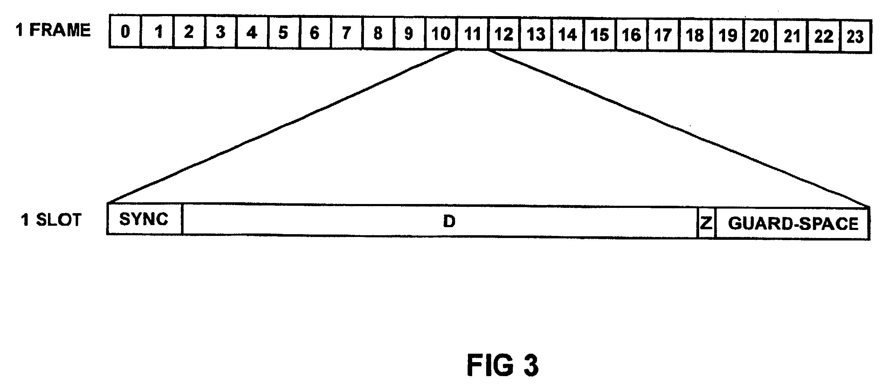

Die Datenübertragung zwischen der Basisstation B und den Mobiltelefonen TE1, TE2, ... TEn (oder anderen Einrichtungen) erfolgt in Einheiten von sogenannten Frames und wird - soweit vorliegend erforderlich - nachfolgend anhand der Figur 3 erläutert. Wie aus der Figur 3 ersichtlich ist, setzt sich ein solcher Frame, genauer gesagt der hier betrachtete DECT-Full-Slot-Frame aus 24 sogenannten Timeslots bzw. Slots (Full-Slots) zusammen. Die ersten 12 der 24 Slots werden von der Basisstation zu den Mobiltelefonen übertragen, und die sich daran anschließenden zweiten 12 Slots werden von den Mobiltelefonen zur Basisstation übertragen. Genauer gesagt werden der nullte Slot eines jedem Frame von der Basisstation zu einem nullten Mobiltelefon, der erste Slot von der Basisstation zu einem ersten Mobiltelefon, der zweite Slot von der Basisstation zu einem zweiten Mobiltelefon, ..., der elfte Slot von der Basisstation zu einem elften Mobiltelefon, und umgekehrt der zwölfte Slot vom nullten Mobiltelefon zur Basisstation, der dreizehnte Slot vom ersten Mobiltelefon zur Basisstation, der vierzehnte Slot vom zweiten Mobiltelefon zur Basisstation, ... und der dreiundzwanzigste Slot vom elften Mobiltelefon zur Basisstation übertragen.

Ein Frame bzw. die 24 Slots eines Frames werden innerhalb von 10 ms übertragen. Jeder Slot umfaßt 480 Bits wird in rund 417 µs (in 416,66 µs) übertragen. Wie aus der Figur 3 ersichtlich ist, verteilen sich die 480 Bis auf ein 32 Bits breites Sync-Feld, ein 388 Bits breites D-Feld, ein 4 Bits breites Z-Feld, und ein 56 Bits breites Guard-Space-Feld.

Für die Übertragung der eigentlich interessierenden Sprachdaten sind 320 Bits innerhalb des D-Feldes reserviert. Die Basisstation kann also innerhalb von 10 ms 320 Bits umfassende Sprachdaten zu jedem der Mobiltelefone versenden und die gleiche Menge an Sprachdaten von jedem der Mobiltelefone empfangen; die Übertragungsrate für Sprachdaten zwischen der Basisstation und jedem der Mobiltelefone beträgt also 32 kBit/s in jede Richtung.

Die Funkfrequenzen, die für den Informations- und Datenaustausch zwischen einer Basisstation B und den Mobiltelefonen TE1 ... TEn verwendet werden, sind aus insgesamt 10 verschiedenen Frequenzen auswählbar; sie werden in Abhängigkeit von den örtlichen Sende- und Empfangsverhältnissen durch die jeweiligen Mobiltelefone bestimmt und können sich aus diesem Grund von Slot zu Slot ändern.

Insbesondere die Basisstation, aber auch die Mobiltelefone, welche im folgenden der Einfachheit halber mit dem Oberbegriff "Funkteile" bezeichnet werden, müssen daher in der Lage sein, die Sende- und Empfangsfrequenz innerhalb kurzer Zeit zu ändern.

Zur Sende- und Empfangsfrequenzumstellung in den Funkteilen eines DECT-Systems gibt es zwei verschiedene Möglichkeiten.

Die eine der Möglichkeiten besteht darin, die Frequenzumstellung während der Dauer des vorstehend bereits erwähnten Guard-Space-Feldes eines jeweiligen Slots durchzuführen. Dies ist möglich, weil im Guard-Space-Feld keine Nutzdaten übertragen werden. Eine solche Frequenzumstellung ist jedoch wegen der Kürze der zur Verfügung stehenden Zeit nur mit einem verhältnismäßig großen Aufwand durchführbar.

Die andere der Möglichkeiten besteht darin, für die Frequenzumstellung jeweils einen eigenen Slot, nämlich einen sogenannten Blind Slot zur Verfügung zu stellen (zu reservieren). Bei dieser Art der Frequenzumstellung wird zwar die maximale Anzahl der an eine Basisstation anschließbaren Mobiltelefone halbiert, doch gestaltet sich die Frequenzumstellung aufgrund der längeren Zeit, die hierfür zur Verfügung steht, erheblich einfacher.

Die Funkteile, in denen von der zuletzt genannten Möglichkeit der Frequenzumstellung Gebrauch gemacht wird, sind sogenannte slow hopping Funkteile und werden im folgenden näher betrachtet.

Um mit verschiedenen Sende- und Empfangsfrequenzen arbeiten zu können, sind die Funkteile vorzugsweise mit Oszillatoren mit veränderbarer Schwingfrequenz ausgestattet. Als Oszillatoren eignen sich insbesondere über eine Phasenregelschleife (PLL) angesteuerte spannungsgesteuerte Oszillatoren (VCO). VCOs und PLLs sind bekannt und bedürfen keiner näheren Beschreibung.

PLLs enthalten bekanntlich einen Phasendetektor, durch den die Phasen einer Referenzschwingung und der Oszillatorschwingung verglichen und ausgewertet werden. Der Phasendetektor gibt ein das Vergleichsergebnis repräsentierendes Signal aus, welches nach einer mehr oder weniger umfangreichen Weiterverarbeitung zur Ansteuerung des VCO verwendet wird und bekanntlich eine sehr genaue Einstellung der Schwingfrequenz des VCO auf einen Sollwert ermöglicht.

Die PLL und der VCO sind bei DECT-Systemen vorzugsweise in einer integrierten Schaltung (IC) untergebracht. Das Ausgangssignal des Phasenkomparators wird in diesem Fall durch eine oder mehrere Ladungspumpen erzeugt.

Die 417 µs eines Blind Slot reichen aus, um die angestrebte Frequenzumstellung durchzuführen. Nachdem der Oszillator auf die neue Frequenz eingeschwungen ist, also spätestens am Ende des betreffenden Blind Slot wird die PLL durch ein zumindest teilweises Abschalten der im Phasendetektor enthaltenen Ladungspumpe(n) (durch ein Abschalten der Arbeitspunktversorgung der Ladungspumpen(n), wodurch diese in einen Bereitschafts- bzw. Stand-By-Modus versetzt werden) deaktiviert.

Die Erfahrung zeigt, daß sich dabei nicht kontrollierbare Entladungsvorgänge einstellen, welche Schwankungen in der VCO-Frequenz hervorrufen.

Um dies zu vermeiden, wurde bislang eine zusätzliche Beschaltung vorgesehen, durch welche dieser Effekt kompensiert wird.

Das Vorsehen dieser zusätzlichen Beschaltung verursacht einen nicht unerheblichen technischen Aufwand, dessen Vermeidung verständlicherweise wünschenswert wäre.

Aus der US 5,103,192 ist eine Ladungspumpensteuerung bekannt geworden, bei der bei einem bestimmten Zustand eines Steuersignals der Ausgang der Ladungspumpe in einen hochohmigen Zustand überführt wird. Auf diese Weise kann der Energieverbrauch der Schaltung minimiert werden. In ähnlicher Weise arbeitet eine Ladungspumpensteuerung, die aus der EP 0 520 558 bekannt geworden ist. In beiden Fällen kann die Beeinflussung des VCO bei der Abschaltung der Ladungspumpe nicht sichergestellt werden.

Der vorliegenden Erfindung liegt daher die Aufgabe zugrunde, das Verfahren gemäß dem Oberbegriff des Patentanspruchs 1 und die Vorrichtung gemäß dem Oberbegriff des Patentanspruchs 7 derart weiterzubilden, daß die Deaktivierung der PLL auf einfache Weise und ohne eine Beeinflussung des VCO durchführbar ist.

Diese Aufgabe wird durch den Gegenstand des Patentanspruchs 1 (Verfahren) bzw. des Patentanspruchs 6 (Vorrichtung) gelöst.

Durch die Verriegelung der Ladungspumpen-Eingangssignale werden die Ladungspumpen-Ausgangssignale, welche zugleich als Ausgangssignal des Phasendetektors der Phasenregelschleife verwendet werden, auf dem momentanen Stand eingefroren. Da die Ladungspumpen-Eingangssignale erst nach dem Einschwingen des Oszillators auf die Sollfrequenz verriegelt werden, haben sie zum Zeitpunkt der Verriegelung einen zeitlichen Verlauf und/oder Werte, die keine Nachregelung der Schwingfrequenz des Oszillators bewirken. Die Verwendung der auf den verriegelten Ladungspumpen-Eingangssignalen basierenden Ladungspumpen-Ausgangssignale zur Oszillator-Ansteuerung bleibt daher ohne Auswirkungen auf den Oszillator. Die Verriegelung der Ladungspumpen-Eingangssignale macht die Phasenregelschleife somit ohne teilweises oder vollständiges Abschalten derselben wirkungslos. Die im wesentlichen unveränderte Aufrechterhaltung des Ladungspumpen-Betriebs sorgt - anders als bisher - für eine gleichbleibende Temperaturverteilung in dem den Oszillator und die Phasenregelschleife enthaltenden Schaltungsbereich und trägt dazu bei, durch Lastwechsel verursachte Versorgungsspannungsschwankungen zu vermeiden.

Der Oszillator kann dadurch unter zeitlich völlig konstanten Bedingungen betrieben werden, wodurch auch dessen Verhalten, insbesondere dessen Schwingfrequenz im wesentlichen stabil gehalten werden kann.

Es wurden mithin ein Verfahren und eine Vorrichtung gefunden, durch welche eine erforderliche Deaktivierung der Phasenregelschleife auf einfache Weise und ohne eine Beeinflussung des Oszillators durchführbar ist.

Vorteilhafte Weiterbildungen der Erfindung sind Gegenstand der Unteransprüche.

Die Erfindung wird nachfolgend anhand eines Ausführungsbeispiels unter Bezugnahme auf die Zeichnung näher erläutert.
Es zeigen
- Figur 1: eine stark schematisierte Darstellung eines erfindungsgemäß ausgebildeten Phasenkomparators einer Phasenregelschleife,
- Figur 2: den Aufbau eines nach dem DECT-Standard arbeitenden Funksystems, und
- Figur 3: das Format der Daten, die zwischen einer Basisstation und mit dieser kommunizierenden Telekommunikationsendeinrichtungen ausgetauscht werden.

Das erfindungsgemäße Verfahren und die erfindungsgemäße Vorrichtung werden nachfolgend anhand der Sende- und/oder Empfangsfrequenzumstellung in einem nach dem DECT-Standard arbeitenden Funksystem beschrieben. Die Anwendung der Erfindung ist jedoch nicht auf einen derartigen Einsatz beschränkt; sie ist grundsätzlich bei der Einstellung der Schwingfrequenz von in beliebigen Einrichtungen für beliebige Zwecke vorgesehenen Oszillatoren anwendbar.

Der prinzipielle Aufbau des betrachteten DECT-Systems unterscheidet sich - abgesehen von den die Phasenregelschleifen-Deaktivierung betreffenden Details - nicht von dem in der Figur 2 veranschaulichten System.

Auch das in der Figur 3 veranschaulichte Format der Daten, die zwischen einer Basisstation und den an dieser eingebuchten Mobiltelefonen ausgetauscht werden, ist gleich. Der Vollständigkeit halber sei an dieser Stelle jedoch erwähnt, daß es neben den in der Figur 3 gezeigten und unter Bezugnahme darauf beschriebenen sogenannten Full-Slots (480 Bits) auch Half-Slots (240 Bits) und Double-Slots (960 Bits) gibt.

Sämtliche Funkteile des DECT-Systems, d.h. sowohl die Basisstation als auch die Mobiltelefone enthalten zum Erzeugen der Sende- und Empfangsfrequenzen einen Oszillator mit veränderbarer Frequenz.

Der besagte Oszillator ist im betrachteten Beispiel ein in einer integrierten Schaltung (IC) integrierter spannungsgesteuerter Oszillator (VCO) mit Phasenregelschleife (PLL).

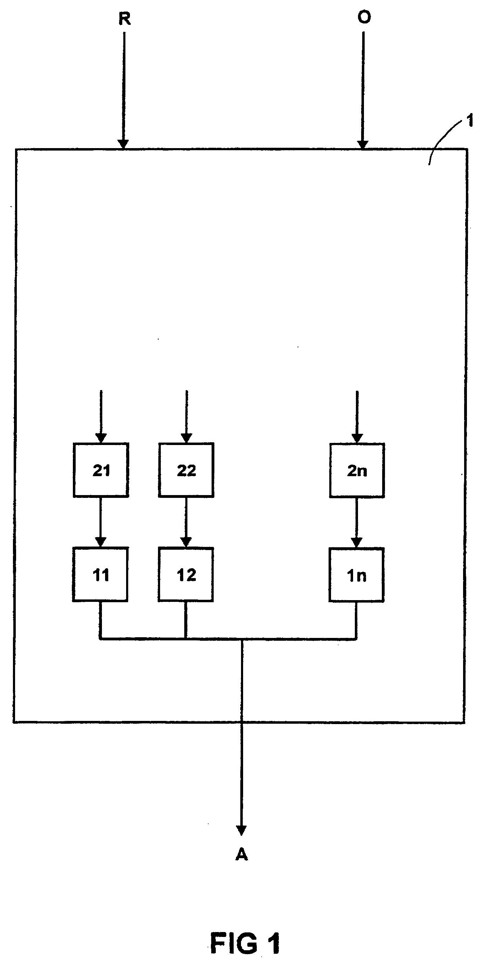

Die Phasenregelschleife enthält einen Phasenkomparator, der schematisch in der Figur 1 dargestellt ist.

Der in der Figur 1 gezeigte Phasenkomparator 1 erhält eine Referenzschwingung R und eine Oszillatorschwingung O als Eingangssignale, wobei die Referenzschwingung R beispielsweise auf die von einem Quarz erzeugte Schwingung zurückgeht, und wobei die Oszillatorschwingung 0 auf die vom VCO erzeugte Schwingung zurückgeht. Aufgabe des Phasenkomparators 1 ist es, gegebenenfalls vorhandene Phasenverschiebungen zwischen der Referenzschwingung R und der Oszillatorschwingung O zu ermitteln und ein vom Ausmaß der Phasenverschiebung abhängendes Ausgangssignal A zu erzeugen. Dieses Ausgangssignal A des Phasenkomparators 1 wird mittelbar oder unmittelbar zur Ansteuerung des VCO verwendet, wodurch sich die Frequenz der von diesem erzeugten Schwingung bekanntlich mit sehr hoher Genauigkeit auf einen Sollwert einstellen läßt.

Das Ausgangssignal A des Phasenkomparators 1 wird im betrachteten Beispiel, wo der VCO und die PLL Bestandteil einer integrierten Schaltung sind, durch eine oder mehrere Ladungspumpen 11, 12 ... 1n gebildet, welche wie in der Figur 1 gezeigt verschaltet sein können. Die Ladungspumpen werden im betrachteten Beispiel jeweils durch die steigende Flanke der Referenzschwingung R aktiviert und durch die steigende Flanke der Oszillatorschwingung 0 in den passiven Zustand zurückversetzt; die Aktivierung und die Deaktivierung kann jedoch auch im Ansprechen auf beliebige andere Flanken der Referenzschwingung R und der Oszillatorschwingung O erfolgen. Insoweit herrscht zwischen den als bekannt vorausgesetzten und den erfindungsgemäßen Verfahren und Vorrichtungen weitgehend Übereinstimmung.

Anders als bisher erfolgt die Deaktivierung der PLL nun jedoch nicht mehr durch ein teilweises oder vollständiges Abschalten der Ladungspumpen 11, 12, ... 1n, sondern durch ein Verriegeln der Ladungspumpen-Eingangssignale.

Zu diesem Zweck sind den Ladungspumpen 11, 12, ... 1n Verriegelungseinheiten 21, 22, ... 2n vorgeschaltet, durch welche die Ladungspumpen-Eingangssignale auf dem momentanen Stand einfrierbar sind.

Im betrachteten Beispiel ist für jede Ladungspumpe 11, 12, ... 1n eine Verriegelungseinheit 21, 22, ... 2n vorgesehen. Wenn an mehrere Ladungspumpen 11, 12, ... 1n die selben Eingangssignale angelegt werden, können die jeweils zugeordneten Verriegelungseinheiten zusammengefaßt werden.

Die Einstellung des VCO auf dessen jeweilige Sollfrequenz erfolgt in sogenannten Blind Slots, welche dem Slot, in dem mit der neuen Frequenz (der Sollfrequenz) gesendet oder empfangen werden soll, jeweils vorangehen. Im Blind Slot selbst werden durch das Funkteil, dessen Oszillator umzustellen ist, keine Nutzdaten versandt oder empfangen.

Erfolgt die Sende- und/oder Empfangsfrequenzumstellung (wie im betrachteten Beispiel) in Blind Slots, so folgen Blind Slots und "normale" Slots abwechselnd aufeinander. Dadurch halbiert sich zwar die maximale Anzahl der Mobiltelefone die an einer Basisstation betrieben werden können, doch können die Basisstation und die Mobiltelefone vor jedem ("normalen") Slot, in dem Nutzdaten empfangen oder versandt werden sollen, mit relativ geringem Aufwand zuverlässig und genau auf eine beliebige Sende- oder Empfangsfrequenz umgestellt werden.

Der Frequenzumstellungsvorgang wird alsbald nach dem Beginn des Blind Slot gestartet. Der VCO wird dabei durch die PLL derart angesteuert, daß sich die von ihm erzeugte Schwingung mehr oder weniger schnell an die Sollfrequenz annähert. Die Sollfrequenz ist spätestens am Ende des Blind Slot erreicht. Wenn die Sollfrequenz erreicht ist bzw. spätestens am oder kurz vor dem Ende des Blind Slot wird die PLL durch Aktivierung der Verriegelungseinheiten 21, 22, ... 2n deaktiviert. Die Aktivierung der Verriegelungseinheiten 21, 22, ... 2n bewirkt eine Verriegelung der Eingangssignale der Ladungspumpen 11, 12, ... 1n, deren Ausgangssignale die Ausgangssignale des Phasenkomparators 1 bilden und - gegebenenfalls nach einer weiteren Verarbeitung - zur VCO-Ansteuerung verwendet werden. Der Phasenkomparator gibt vom Zeitpunkt der Verriegelung der Ladungspumpen-Eingangssignale an dauerhaft exakt das Ausgangssignal aus, das er zum Zeitpunkt der Aktivierung der Verriegelungseinheiten 21, 22, ... 2n ausgab. Dieses vom Phasenkomparator ausgegebene Signal verursacht keine Nachregelung des VCO, da dieser ja zum Zeitpunkt der Verriegelung der Ladungspumpen-Eingangssignale bereits auf die Sollfrequenz eingeschwungen war und folglich keiner Nachregelung durch die PLL bzw. den Phasenkomparator bedurfte.

Um dies unter allen Umständen sicherzustellen, ist vorgesehen, die Aktivierung der Verriegelungseinheiten (die Verriegelung der Ladungspumpen-Eingangssignale) nur durchzuführen, wenn die Ausgangssignale der Ladungspumpen 11, 12, ... 1n (des Phasenkomparators 1) solche Werte und/ oder einen solchen zeitlichen Verlauf aufweisen, daß dadurch keine Nachregelung des VCO bewirkt wird. Dies wird dadurch erreicht, daß die Verriegelung der Ladungspumpen 11, 12, ... 1n zu einem Zeitpunkt erfolgt, bei dem davon ausgegangen werden kann, daß die Ladungspumpen inaktiv sind. Dieser Zeitpunkt kann innerhalb weiter Grenzen frei gewählt werden und wird vorliegend durch eine der nicht zur Aktivierung oder Deaktivierung der Ladungspumpen 11, 12, ... 1n herangezogenen Flanken der Referenzschwingung R oder der Oszillatorschwingung 0, also hier durch eine der fallenden Flanken der besagten Schwingungen definiert.

Die Verriegelung der Ladungspumpen-Eingangssignale wird über das Ende des Blind Slot hinaus aufrechterhalten. Der - abgesehen von der Verriegelung der Ladungspumpen-Eingangssignale - unverändert weitergeführte Betrieb von VCO und PLL sorgt dafür, daß - anders als beim Abschalten der PLL oder Teilen derselben - keine Temperaturschwankungen in dem den VCO und die PLL enthaltenden Schaltungsbereich und keine durch Lastwechsel verursachte Versorgungsspannungsschwankungen auftreten (können). Die sonst dadurch verursachten Frequenzschwankungen der Oszillatorschwingung können dadurch vollständig oder zumindest größtenteils vermieden werden. Gegebenenfalls noch vorhandene kleinere Schwankungen und Veränderungen der Oszillatorschwingungsfrequenz sind tolerierbar, weil sich der Slot, in welchem die wie beschrieben eingestellte Sende- oder Empfangsfrequenz zum Senden oder Empfangen von Daten verwendet wird, unmittelbar an den (Blind) Slot anschließt, in welchem sie eingestellt wurde. Die Verriegelung der Ladungspumpen-Eingangssignale wird natürlich spätestens dann, wenn eine erneute wie beschrieben durchgeführte Frequenzumstellung durchzuführen ist (begonnen wird), wieder aufgehoben.

Wie aus den vorstehenden Erläuterungen hervorgeht, wird die PLL durch die Aktivierung der Verriegelungseinheiten 21, 22, ... 2n deaktiviert. Die Verriegelungseinheiten 21, 22, ... 2n wirken damit unabhängig von deren Anzahl als Phasenregelschleifen- bzw. PLL-Deaktivierungseinrichtung.

Das beschriebene Verfahren und die beschriebene Vorrichtung zur PLL-Deaktivierung ermöglichen es, die Deaktivierung der PLL auf einfache Weise und ohne eine Beeinflussung des VCO durchzuführen.

## Patentansprüche

1. Verfahren zum Einstellen der Schwingfrequenz eines Oszillators unter Verwendung einer eine oder mehrere Ladungspumpen (11, 12, .. 1n) enthaltenden Phasenregelschleife auf einen vorbestimmten Sollwert, wobei die Phasenregelschleife nach dem Einschwingen des Oszillators deaktiviert wird, wobei die Deaktivierung der Phasenregelschleife durch ein Verriegeln der Ladungspumpen-Eingangssignale erfolgt, wodurch die Ladungspumpen-Ausgangssignale auf dem momentanen Stand eingefroren werden,
**dadurch gekennzeichnet,**
**daß** der Zeitpunkt zur Verriegelung der Ladungspumpen-Eingangssignale durch eine bestimmte Flanke der durch den Phasendetektor (1) zu vergleichenden Schwingungen (O, R) definiert wird, bei der die Ladungspumpen inaktiv sind.

2. Verfahren nach Anspruch 1,
**dadurch gekennzeichnet,**
**daß** das Ausgangssignal der mindestens einen Ladungspumpe (11, 12, ... 1n) als Ausgangssignal eines Phasendetektors (1) der Phasenregelschleife verwendet wird.

3. Verfahren nach Anspruch 1 oder 2,
**dadurch gekennzeichnet,**
**daß** das Verriegeln der Ladungspumpen-Eingangssignale zu einem Zeitpunkt durchgeführt wird, zu dem durch die Ladungspumpen-Ausgangssignale keine Nachregelung des Oszillators bewirkt wird.

4. Verfahren nach einem der vorhergehenden Ansprüche,
**dadurch gekennzeichnet,**
**daß** durch das Einstellen der Schwingfrequenz des Oszillators eine Sende- oder Empfangsfrequenzumstellung in einem zu einem nach dem DECT-Standard arbeitenden Funksystem gehörenden Funkteil (B, TE1, TE2, .. TEn) erfolgt.

5. Verfahren nach Anspruch 4,
**dadurch gekennzeichnet,**
**daß** das Einstellen der Schwingfrequenz innerhalb eines Blind Slot eines DECT-Frame erfolgt.

6. Vorrichtung zum Einstellen der Schwingfrequenz eines Oszillators unter Verwendung einer eine oder mehrere Ladungspumpen (11, 12, ... 1n) enthaltenden Phasenregelschleife auf einen vorbestimmten Sollwert, wobei die Phasenregelschleife nach dem Einschwingen des Oszillators deaktiviert wird, wobei eine Phasenregelschleifen-Deaktivierungseinrichtung (21, 22, ... 2n), welche in der Lage ist, die Deaktivierung der Phasenregelschleife durch ein Verriegeln der Ladungspumpen-Eingangssignale durchzuführen, wodurch die Ladungspumpen-Ausgangssignale auf dem momentanen Stand eingefroren werden,
**dadurch gekennzeichnet,**
**daß** die Phasenregelschleifen-Deaktivierungseinrichtung (21, 22, ... 2n) derart gestaltet ist, daß der Zeitpunkt zur Verriegelung der Ladungspumpen-Eingangssignale durch eine bestimmte Flanke der durch den Phasendetektor (1) zu vergleichenden Schwingungen (O, R) definiert wird, bei der die Ladungspumpen inaktiv sind.

7. Vorrichtung nach Anspruch 6,
**dadurch gekennzeichnet,**
**daß** der Oszillator und die Phasenregelschleife Bestandteil einer integrierten Schaltung sind.

8. Vorrichtung nach Anspruch 6 oder 7,
**dadurch gekennzeichnet,**
**daß** die integrierte Schaltung Bestandteil eines Funkteils (B, TE1, TE2, ... TEn) eines nach dem DECT-Standard arbeitenden Funksystems ist.

9. Vorrichtung nach einem der Ansprüche 6 bis 8,
**dadurch gekennzeichnet,**
**daß** die mindestens eine Ladungspumpe (11, 12, ... 1n) Bestandteil eines Phasenkomparators (1) der Phasenregelschleife ist.

## Claims

1. Method for setting the oscillation frequency of an oscillator using a phase locked loop which contains one or more charge pumps (11, 12, .. 1n) to a predetermined nominal value, with the phase locked loop being deactivated once the oscillator has stabilized, and with the phase locked loop being deactivated by locking of the charge pump input signals, as a result of which the charge pump output signals are frozen at the instantaneous state,
**characterized**
**in that** the time for locking of the charge pump input signals is defined by a specific flank of the oscillations (O, R) to be compared by the phase detector (1), on which specific flank the charge pumps are inactive.

2. Method according to Claim 1,
**characterized**
**in that** the output signal from the at least one charge pump (11, 12, ... 1n) is used as the output signal from a phase detector (1) for the phase locked loop.

3. Method according to Claim 1 or 2,
**characterized**
**in that** the charge pump input signals are locked at a time at which no readjustment of the oscillator is being caused by the charge pump output signals.

4. Method according to one of the preceding claims,
**characterized**
**in that** the setting of the oscillation frequency of the oscillator is used to carry out a transmission or reception frequency change in a radio part (B, TE1, TE2, .. TEn) which is part of a radio system that operates in accordance with the DECT Standard.

5. Method according to Claim 4,
**characterized**
**in that** the oscillation frequency is set within a blind slot in a DECT frame.

6. Apparatus for setting the oscillation frequency of an oscillator using a phase locked loop which contains one or more charge pumps (11, 12, .. 1n) to a predetermined nominal value, with the phase locked loop being deactivated once the oscillator has stabilized, with a phase locked loop deactivation device (21, 22, ... 2n) which is able to deactivate the phase locked loop by locking of the charge pump input signals, as a result of which the charge pump output signals are frozen at the instantaneous state,
**characterized**
**in that** the phase locked loop deactivation device (21, 22, ... 2n) is designed such that the time at which the charge pump input signals are locked is defined by a specific flank of the oscillations (O, R) to be compared by the phase detector (1), on which specific flank the charge pumps are inactive.

7. Apparatus according to Claim 6,
**characterized**
**in that** the oscillator and the phase locked loop are components of an integrated circuit.

8. Apparatus according to Claim 6 or 7,
**characterized**
**in that** the integrated circuit is a component of a radio part (B, TE1, TE2, ... TEn) in a radio system which operates in accordance with the DECT Standard.

9. Apparatus according to one of Claims 6 to 8,
**characterized**
**in that** the at least one charge pump (7, 12, ... 1n) is a component of a phase comparator (1) for the phase locked loop.

## Revendications

1. Procédé pour régler la fréquence d'oscillation d'un oscillateur sur une valeur de consigne prédéterminée en utilisant une boucle à verrouillage de phase contenant une ou plusieurs pompes de charge (11, 12, ..., 1n), la boucle à verrouillage de phase étant désactivée après que l'oscillateur est entré en régime permanent ; la désactivation de la boucle à verrouillage de phase s'effectuant au moyen d'un verrouillage des signaux d'entrée de pompes de charge, ce qui gèle les signaux de sortie de pompes de charge dans leur état momentané,
**caractérisé par le fait que** l'instant pour le verrouillage des signaux d'entrée de pompes de charge est défini par un certain front des oscillations (O, R), à comparer par le détecteur de phase (1), pour lequel les pompes de charge sont inactives.

2. Procédé selon la revendication 1,
**caractérisé par le fait que** le signal de sortie de l'au moins une pompe de charge (11, 12, ..., 1n) est utilisé comme signal de sortie d'un détecteur de phase (1) de la boucle à verrouillage de phase.

3. Procédé selon la revendication 1 ou 2,
**caractérisé par le fait que** le verrouillage des signaux d'entrée de pompes de charge est effectué à un instant auquel aucune post-régulation de l'oscillateur n'est provoquée par les signaux de sortie de pompes de charge.

4. Procédé selon l'une des revendications précédentes,
**caractérisé par le fait que**, par le réglage de la fréquence d'oscillation de l'oscillateur, il s'effectue un changement de fréquence d'émission ou de réception dans un élément radio (B, TE1, TE2, ..., TEn) appartenant à un système radio fonctionnant selon le standard DECT.

5. Procédé selon la revendication 4,
**caractérisé par le fait que** le réglage de la fréquence d'oscillation s'effectue à l'intérieur d'un faux créneau (Blind Slot) d'une trame DECT.

6. Dispositif pour régler la fréquence d'oscillation d'un oscillateur sur une valeur de consigne prédéterminée en utilisant une boucle à verrouillage de phase contenant une ou plusieurs pompes de charge (11, 12, ..., 1n), la boucle à verrouillage de phase étant désactivée après que l'oscillateur est entré en régime permanent; un dispositif de désactivation de boucle à verrouillage de phase (21, 22, ..., 2n) étant capable d'effectuer la désactivation de la boucle à verrouillage de phase par un verrouillage des signaux d'entrée de pompes de charge, ce qui gèle les signaux de sortie de pompes de charge dans leur état momentané,
**caractérisé par le fait que** le dispositif de désactivation de boucle à verrouillage de phase (21, 22, ..., 2n) est conçu de telle sorte que l'instant pour le verrouillage des signaux d'entrée de pompes de charge est défini par un certain front des oscillations (O, R) , à comparer par le détecteur de phase (1), pour lequel les pompes de charge sont inactives.

7. Dispositif selon la revendication 6,
**caractérisé par le fait que** l'oscillateur et la boucle à verrouillage de phase font partie d'un circuit intégré.

8. Dispositif selon la revendication 6 ou 7,
**caractérisé par le fait que** le circuit intégré fait partie d'un élément radio (B, TE1, TE2, ..., TEn) d'un système radio fonctionnant selon le standard DECT.

9. Dispositif selon l'une des revendications 6 à 8,
**caractérisé par le fait que** l'au moins une pompe de charge (11, 12, ..., 1n) fait partie d'un comparateur de phase (1) de la boucle à verrouillage de phase.
